# EUROPEAN PATENT SPECIFICATION

(11) **EP 3 197 036 B1**
(45) Date of publication and mention of the grant of the patent: **16.02.2022**
(21) Application number: 15841765.9
(22) Date of filing: 21.08.2015
(51) Int. Cl.: H02M 1/32, H02M 1/08, G01R 31/42, H02P 29/60, H02M 7/48

(54) **POWER CONVERSION DEVICE**
STROMWANDLUNGSVORRICHTUNG
DISPOSITIF DE CONVERSION DE PUISSANCE

(30) Priority: 19.09.2014 JP 2014190673
(43) Date of publication of application: 26.07.2017
(73) Proprietor: Hitachi, Ltd., Tokyo 100-8280 (JP)
(72) Inventor: SAKANO Junichi, Tokyo 100-8280 (JP); ONDA Kohhei, Tokyo 100-8280 (JP); TAMAKOSHI Takeshi, Tokyo 100-8280 (JP)
(74) Representative: MERH-IP Matias Erny Reichl Hoffmann Patentanwälte PartG mbB
(86) International application number: PCT/JP2015/073451
(87) International publication number: WO 2016/042970

(56) References cited:
- JP-A- H1 124 762
- JP-A- H05 281 291
- JP-A- H07 170 724
- JP-A- 2004 140 891
- JP-A- 2008 172 938
- US-A1- 2010 231 269
- US-A1- 2013 187 656
- MARCO ANTONIO RODRIGUEZ-BLANCO ET AL: "A Failure-Detection Strategy for IGBT Based on Gate-Voltage Behavior Applied to a Motor Drive System", IEEE TRANSACTIONS ON INDUSTRIAL ELECTRONICS, IEEE SERVICE CENTER, PISCATAWAY, NJ, USA, vol. 58, no. 5, 1 May 2011 (2011-05-01), pages 1625-1633, XP011352934, ISSN: 0278-0046, DOI: 10.1109/TIE.2010.2098355
- RODRIGUEZ-BLANCO M A ET AL: "IGBT fault diagnosis using adaptive thresholds during the turn-on transient", 2013 9TH IEEE INTERNATIONAL SYMPOSIUM ON DIAGNOSTICS FOR ELECTRIC MACHINES, POWER ELECTRONICS AND DRIVES (SDEMPED), IEEE, 27 August 2013 (2013-08-27), pages 241-248, XP032514206, DOI: 10.1109/DEMPED.2013.6645723 [retrieved on 2013-10-23]
- YVAN AVENAS ET AL: "Temperature Measurement of Power Semiconductor Devices by Thermo-Sensitive Electrical Parameters A Review", IEEE TRANSACTIONS ON POWER ELECTRONICS, INSTITUTE OF ELECTRICAL AND ELECTRONICS ENGINEERS, USA, vol. 27, no. 6, 1 June 2012 (2012-06-01), pages 3081-3092, XP011436337, ISSN: 0885-8993, DOI: 10.1109/TPEL.2011.2178433
- None

## Description

### Technical Field

The present invention relates to a power converting device. More particularly, the present invention relates to a power converting device which is used for a large-volume frequency converting device for use to control electric motors for railway vehicles and large industries, and for power systems, and includes a power semiconductor switching element.

### Background Art

Conventionally, as a technique of avoiding damages on a device when a power semiconductor abnormally operates, there is a technique of comparing a control drive instruction signal for a drive circuit which drives the power semiconductor, and operation information for detecting an operation state where the drive circuit drives the power semiconductor to conduct or interrupt, and determining the abnormal operation of the drive circuit when a mismatch continues for a certain period of time (see, for example, PTL 1).

Further, conventionally, as a technique of directly sensing a temperature abnormality of a semiconductor chip, there is a technique of detecting a control instruction signal and a delay time taken until the power semiconductor is interrupted, and thereby detecting a temperature rise of a power bipolar transistor (see, for example, PTL 2).In US 2013/0187656 A1, a gate driver unit includes an input stage, an output stage, and a monitoring stage. The monitoring stage is configured to capture and evaluate signals of a power switch connected to the gate driver unit and synchronize the evaluation of the signals of the power switch to the control signals. In US 2010/0231269 A1, a drive circuit is described. Abnormality of the semiconductor element is prevented from being erroneously sensed in case where a gate "on" command has entered in a state in which a gate voltage of the semiconductor element has not lowered fully. In MARCO ANTONIO RODRIGUEZ-BLANCO ET AL: "A Failure Detection Strategy for IGBT Based on Gate-Voltage Behavior Applied to a Motor Drive System", (IEEE TRANSACTIONS ON INDUSTRIAL ELECTRONICS, vol. 58, no. 5, 1 May 2011, XP011352934), a failure-detection strategy is described for IGBT-based motor drive systems. In RODRIGUEZ-BLANCO ET AL: "IGBT fault diagnosis using adaptive thresholds during the turn-on transient" (2013 9TH IEEE INTERNATIONAL SYMPOSIUM ON DIAGNOSTICS FOR ELECTRIC MACHINES, POWER ELECTRONICS AND DRIVES, XP032514206) fault diagnosis is described using adaptive thresholds. In YVAN AVENAS ET AL: "Temperature Measurement of Power Semiconductor Devices by Thermo-Sensitive Electrical Parameters A Review", (IEEE TRANSACTIONS ON POWER ELECTRONICS, INSTITUTE OF ELECTRICAL AND ELECTRONICS ENGINEERS, USA, XP011436337) thermal measurements of a power semiconductor device are described.

### Citation List

### Patent Literature

PTL 1: JP 5049817 B2
PTL 2: JP 7-170724 A

### Summary of Invention

### Technical Problem

A power converter such as a large-volume frequency converter for use to control electric motors for railway vehicles and large industries and for power systems controls power of a high voltage and a large current. However, when an element failure occurs, a power supply short-circuits, and the power converter is likely to fall in a remarkable troubled state. It is necessary to stop a power converter as early as possible and avoid damages on the device when a power semiconductor abnormally operates to prevent such a situation. Hence, there is adopted an abnormality detecting method for comparing a control drive instruction signal for a drive circuit which drives the power semiconductor, and operation information for detecting an operation state where the drive circuit drives the power semiconductor to conduct or interrupt, and determining the abnormal operation of the drive circuit when a mismatch continues for a certain period of time. A conventional example of such a method is the technique disclosed in PTL 1, and FIG. 7 illustrates a configuration example of this method. When such a method is used, it is possible to determine an abnormal operation of the drive circuit. However, such a detecting method can detect an abnormality for the first time when a power supply of a power semiconductor is short-circuited, and therefore can prevent damages on the device yet has difficulty in continuing operating in this state due to a concern of a repeated occurrence of the abnormal operations. Further, when the power supply short-circuits due to a failure of the power semiconductor, an operation itself becomes impossible.

Hence, it is desirable to detect in advance an abnormality of a device which results in such power supply short-circuiting, and take an appropriate measure. Hence, there is a method for, for example, providing a temperature sensor near a power semiconductor and detecting an overtemperature abnormality of the power semiconductor. However, this method has difficulty in detecting a temperature rise of a semiconductor chip caused by a rise in a thermal resistance in the power semiconductor. Hence, it is demanded to directly detect a temperature abnormality of the semiconductor chip. A technique disclosed in PTL 2 is conventionally such a technical example. FIG. 8 illustrates a configuration example of the technique. In this example, by detecting a control instruction signal and a delay time taken until a power semiconductor is interrupted, a temperature rise of a power bipolar transistor is detected.

In this example, a circuit which determines an output voltage of the power semiconductor is necessary to detect an abnormal rise in a temperature of the power semiconductor. However, a large-volume power converting device controls a high voltage. Therefore, it is difficult to install a voltage divider of a large size, it is necessary to provide at least six power semiconductors when three-phase alternating currents are controlled and provide at least three voltage dividers to evaluate voltages of the power semiconductors, it is necessary to take a measure for significant noise during switching since a large current is handled, and therefore it is difficult to apply the large-voltage power converting device.

Hence, an object is to precisely detect an abnormality and deterioration of a power semiconductor and a power converting device related to the power semiconductor device and precisely prevent a trouble such as a failure while employing a simple configuration. Further, an object is to provide a method for enabling long-term use of the power semiconductor and the power converting device.

### Solution to Problem

The aforementioned object is solved by the invention according to the independent claim 1. Further preferred developments are described by the dependent claims. In particular, a power converting device according to the present invention is, for example, a power converting device which includes a power semiconductor device; and an arithmetic operation circuit which gives a drive instruction to the power semiconductor, and the power converting device has a function of calculating for a drive instruction to conduct or interrupt the power semiconductor a delay time taken until an output voltage of a drive circuit applied to the power semiconductor in response to a change in the drive instruction reaches a determination value, and compares and determines the delay time and a reference value under a specific drive condition, records or displays and outputs a result of the determination, or changes at least one of the drive instruction and the drive voltage based on a result of the comparison and the determination.

### Advantageous Effects of Invention

According to the present invention, it is possible to provide a method which can precisely detect an abnormality or detection of a power semiconductor and a power converting device related to the power semiconductor and precisely prevent a trouble such as a failure while employing a simple configuration, and which enables long-term use of the power semiconductor and the power converting device.

### Brief Description of Drawings

[FIG. 1] FIG. 1 is a view illustrating a block configuration of a power converting device according to Example 1 which is an embodiment not covered by the claimed invention the present invention.
[FIG. 2] FIG. 2 is a view illustrating a waveform of each signal of the power converting device according to Example 1.
[FIG. 3] FIG. 3 is a view illustrating a block configuration of a power converting device according to example 2 which is an embodiment not covered by the claimed invention.
[FIG. 4] FIG. 4 is a view illustrating a waveform of each signal of the power converting device according to example 2.
[FIG. 5] FIG. 5 is a view illustrating a block configuration of a power converting device according to example 3 which is Embodiment 1 of the present invention.
[FIG. 6] FIG. 6 is a view illustrating a block configuration of a power converting device according to example 4 which is Embodiment 2 of the present invention.

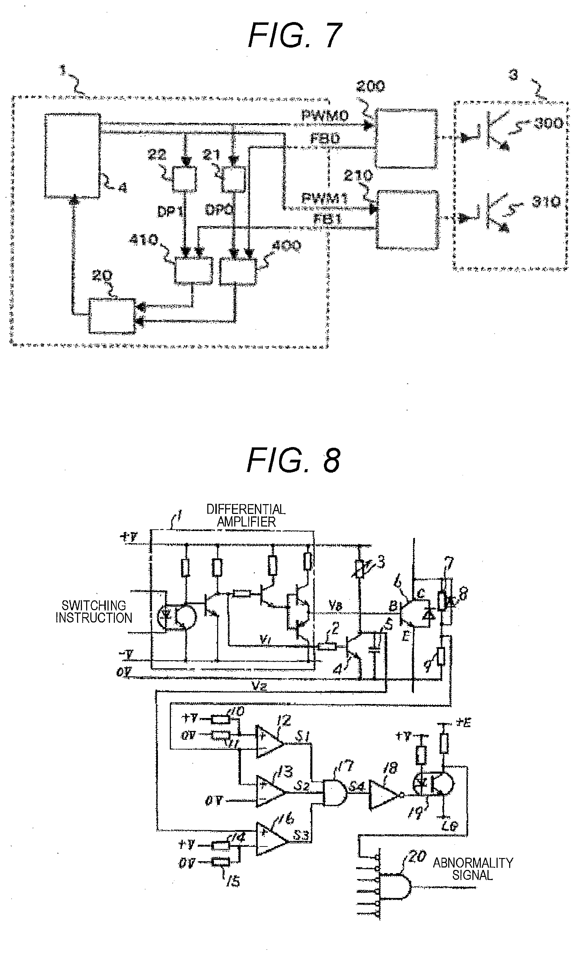

[FIG. 7] FIG. 7 is a view illustrating an example of a conventional power converting device.
[FIG. 8] FIG. 8 is a view illustrating another example of the conventional power converting device.

### Description of Embodiments and Examples

A power converting device according to the present invention is a power converting device which includes a power semiconductor device; and an arithmetic operation circuit which gives a drive instruction to the power semiconductor, and the power converting device has a function of calculating for a drive instruction to conduct or interrupt the power semiconductor a delay time taken until an output voltage of a drive circuit applied to the power semiconductor in response to the drive instruction reaches a determination value, and compares and determines the delay time and a reference value under a specific drive condition, records or displays and outputs a result of the determination, or changes at least one of the drive instruction and the drive voltage based on a result of the comparison and the determination. For the power semiconductor, an insulation gate bipolar transistor, a power MOSFET or a MOS gate control power semiconductor element may be used. According to this configuration, the specific drive condition for making comparison and determination using the reference value may be configured to be one of an output current value of the power converting device, a direction of an output current flowing in the power semiconductor, an inter-output terminal voltage of the power semiconductor, a power voltage and a temperature in the power converting device or may be configured to be a combination of the output current value, the direction, the inter-output terminal voltage, the power voltage and the temperature. Further, the delay time measured in advance by the power converting device may be recorded and a value calculated by performing an arithmetic operation on a value of the delay time may be used for the reference value used to make comparison with and determination on the delay time. Furthermore, when a result obtained by the comparison and the determination is recorded, and a number of times of the recording or a time interval of the recording satisfies a given condition, a display output or at least one of the drive instruction and the drive voltage may be configured to be changed. Still further, the drive instruction or the drive voltage may be configured to be changed to interrupt the power semiconductor for a certain period of time based on a result of the comparison and the determination. Moreover, a time width of a conduction instruction of the power semiconductor according to the drive instruction may be configured to be decreased based on a result of the comparison and the determination. Besides the power converting device may further include: means which communicates a signal of the drive instruction, and a signal of a result indicating that the output voltage of the drive circuit has reached the determination value between the arithmetic operation circuit and the power semiconductor; and a determination circuit which receives an input of the signal of the communication means and a signal related to the specific drive condition, and compares and determines the delay times and the reference value, and a result of the determination may be configured to be outputted to the arithmetic operation circuit or the drive circuit. Further, the power converting device may be configured to include communication means which records the result of the determination and outputs a result of the recording to an outside.

Embodiments and examples of a power converting device according to the present invention will be described in detail below as each example with reference to drawings.

### Example 1

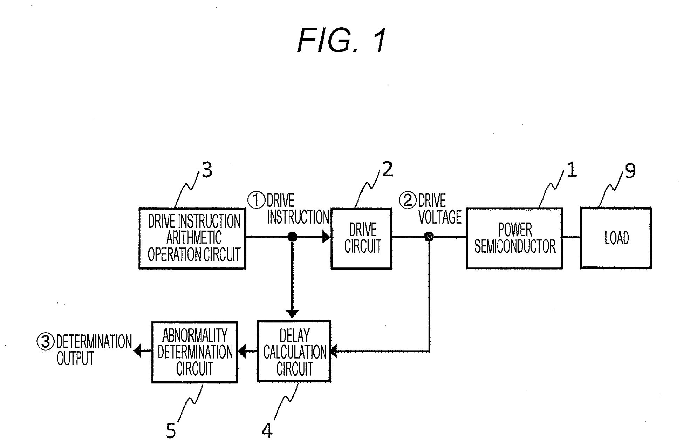

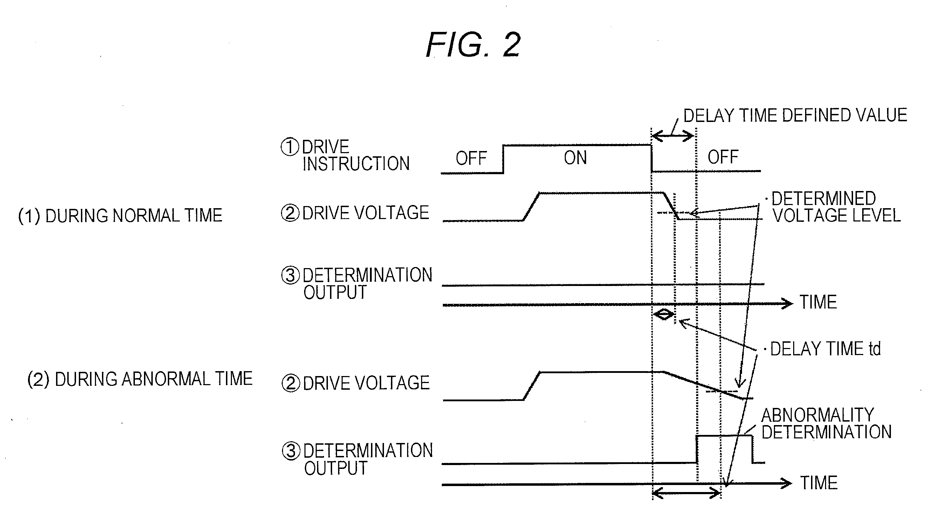

FIG. 1 illustrates a block configuration of a power converting device according to Example 1 which is an embodiment not covered by the claimed invention, and FIG. 2 illustrates examples of a drive signal, a control voltage and a determined output waveform. A drive circuit 2 in the power converting device according to the present invention in FIG. 1 converts a drive instruction generated by a drive instruction arithmetic operation circuit 3 into a drive voltage, and controls conduction and interruption of a power semiconductor 1 and thereby drives a load 9. A delay calculation circuit 4 calculates for the drive instruction a delay time taken until the drive voltage reaches a fixed determination value in response to a change in the drive instruction, and an abnormality determination circuit 5 compares a value of the delay time and a reference value, and outputs a comparison result. FIG. 2 illustrates a waveform according to an embodiment of the present invention when the power semiconductor is interrupted, i.e., is turned off. A drive voltage changes with a delay time td from the same drive instruction during a normal time. Characteristics of the power semiconductor change this delay time based on a condition. Our survey has confirmed that this delay time depends on a temperature of the power semiconductor. Power semiconductors generally have such temperature dependence. However, compared to an output voltage of a control circuit of a bipolar transistor equal to or less than 1 V, an output voltage of a control circuit of a MOS gate control element has a high amplitude of several V to several ±10 V, and a large margin with respect to noise caused during conduction and interruption of a power semiconductor is secured. Consequently, it is possible to enhance delay time evaluation precision.

For example, an insulation gate bipolar transistor which is a MOS gate control power semiconductor, i.e., an IGBT can measure and confirm an increase in a delay time of approximately 1 ns per 1°C of a temperature rise in the power semiconductor by setting an appropriate state determination voltage during on/off switching at +15 V and -12 V of a voltage amplitude of a control circuit. This reflects a threshold of a control voltage for turning on and off the power converting device and temperature dependency of a delay time for conducting and interrupting a current. Hence, MOSFET and other MOS control power converting devices also have the same temperature dependency, and can detect a temperature change by determining a delay time.

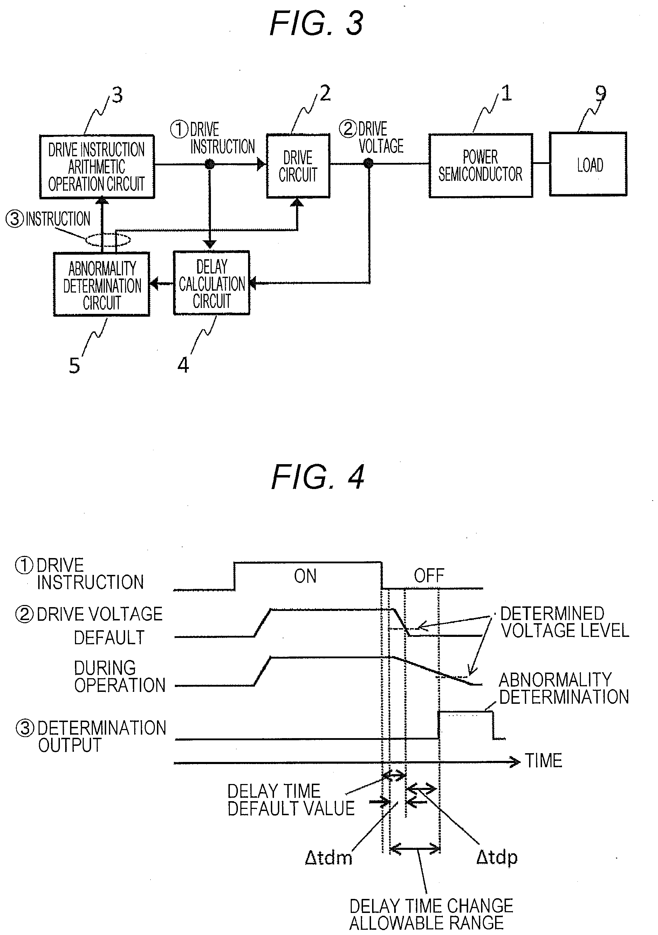

As is clear from a signal waveform in FIG. 2, Example 1 employs a configuration where, when the delay time td increases compared to a defined value or more corresponding to a given fixed temperature rise, abnormality determination is outputted. Consequently, it is possible to detect that the temperature of the power semiconductor becomes the defined value or more and take a measure for preventing damages on the power converting device according to an output of this determination. FIG. 3 illustrates a power converting device according to an embodiment not covered by the claimed invention, and illustrates a configuration where a drive instruction and a drive voltage are changed to prevent damages on the power converting device based on an abnormality determination result. A specific measure for preventing damages on the power converting device according to the example is configured to include turning off power the power semiconductor whose temperature rise has been detected for a certain period of time, turning off another power converting device related to a temperature rise of a power conversion semiconductor whose temperature rise has been detected in a power converting device for a certain period of time, or changing a drive instruction for a certain period of time and outputting a drive instruction to prevent heat generation of a power conversion semiconductor whose temperature rise has been detected. Further, the specific measure may be configured to include outputting a control voltage for forcibly turning off a power semiconductor irrespectively of a drive instruction, based on a determination output of a detected temperature rise to take a measure for an abnormality at a high speed.

Furthermore, a configuration where a drive instruction is changed for a certain period of time and is outputted to prevent heat generation of a power conversion semiconductor whose temperature rise has been detected includes decreasing heat generation of the power conversion semiconductor by limiting and lowering an upper limit value of a current flowing in the power semiconductor for a certain period of time from a point of time at which the temperature rise has been detected, setting or decreasing an upper limit of a time width of a conduction instruction for turning on the power semiconductor, decreasing a period in which a current flows and a temperature rises, and increasing a period in which the power semiconductor is turned off and the temperature lowers, or decreasing a control cycle, decreasing the number of times of switching and decreasing switching loss caused by conduction and interruption.

In this regard, FIG. 2 illustrates the configuration example where, when the delay time td increases to the defined value or more, abnormality determination is outputted. However, there is a case, too, where a delay time decreases during a temperature rise depending on operation conditions such as a difference in element characteristics and an output current. In this case, when the delay time td decreases, a defined value may be set to make abnormality determination.

### Example 2

FIG. 3 illustrates a block configuration of a power converting device according to example 2 which is an embodiment not covered by the claimed invention, and FIG. 4 illustrates a signal waveform of the power converting device. This example differs from Example 1 in a method for determining an abnormality yet the other points are the same as those of Example 1. This example employs a configuration where a delay time Δtd measured in advance by the power converting device is recorded, and is compared with a minimum value Δtdm and a maximum value Δtdp of an delay time change allowable range calculated and set based on a value of the delay time Δtd during an operation, and, when the delay time Δtd deviates from this range, abnormality determination is outputted. Consequently, it is possible to detect that the temperature of the power semiconductor becomes the defined value or more and take a measure for preventing damages on the power converting device according to an output of this determination. The same method described above can be adopted for a measure for presenting damages.

### Example 3

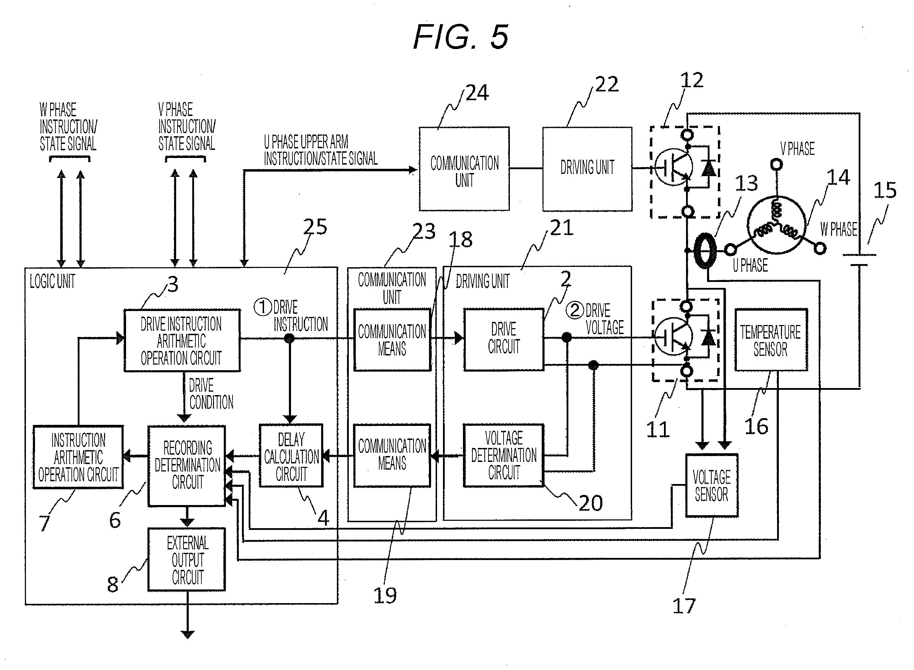

FIG. 5 illustrates a block configuration of a power converting device according to example 3 which is the first embodiment of the present invention, illustrates a two-level power converting device of three phases which is connected to a power supply 15 and includes a three-phase electric motor 14 as a load, and illustrates details of a configuration of recording a drive condition for determining a delay time and a determination result, and changing a drive instruction based on based on a determination result. The figure illustrates details of a circuit which controls a U phase lower arm, and a U phase upper arm and other V phase and W phase also employ the same configuration. An IGBT which is a power semiconductor 11 of the U phase lower arm relays a drive instruction from a drive instruction arithmetic operation circuit 3 of a logic unit 25 via communication means 18 of a communication unit 23, and is driven by a drive voltage applied between gate and emitter terminals of the IGBT which is an output of a drive circuit 2. A voltage determination circuit 20 compares this drive voltage and a defined value to determine whether this drive voltage is higher or lower than the defined value, and transmits a comparison and determination result to the logic unit 25 via the communication means 19. A delay calculation circuit calculates a delay time of the drive instruction and this transmitted determination result, and inputs the delay time to a recording determination circuit 6. The recording determination circuit 6 records a delay time at a set timing and under a drive condition. In this case, the drive condition applies when at least one or more drive conditions including a drive instruction condition such as a current instruction value from a drive instruction arithmetic operation circuit, a temperature, a current value and a current flowing direction determined based on signals from a temperature sensor 16, a current sensor 13 and a voltage sensor 17 installed near the IGBT, and a voltage applied to the power semiconductors match with set drive conditions. In this regard, the voltage sensor monitors a voltage applied to the power semiconductors, yet may monitor the voltage of the power supply 15. Further, the set timing is desirably a time at which the power converting device starts operating or a time at which maintenance is finished, i.e., a time at which temporal deterioration of the power converting device can be ignored.

The delay time recorded in this way and a subsequent delay time under a defined drive condition during an operation of the power converting device are compared on a regular basis and, when a delay time change amount exceeds a set value or the number of times that the delay time change amount exceeds the set value exceeds a fixed frequency, an abnormality is determined. Further, the delay time is recorded at a fixed timing or a point of time at which an abnormality is determined, and, when the delay time change amount exceeds a fixed change amount during this recording time, an abnormality can be determined, too. In this regard, a drive condition for recording or determining a delay time defined herein does not need to be one condition and, by increasing the number of conditions, it is possible to further enhance temperature rise determination precision.

The external output circuit 8 is configured to output the delay time recorded by the recording determination circuit 6 and a drive condition in this case together, and an external PC can perform numerical analysis and history survey, and evaluate whether or not there is an abnormality and a remaining operational life in detail. Further, the instruction arithmetic operation circuit 7 changes a drive instruction according to an abnormality determination result, so that it is possible to reduce heat generation of the power semiconductor. Even when the power semiconductor deteriorates, it is possible to enable long-term use by reducing an output of the power semiconductor by the above-described method.

### Example 4

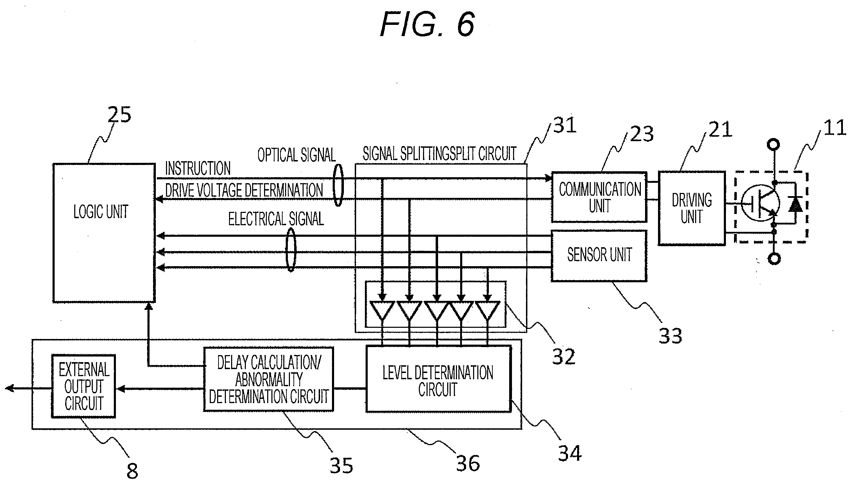

FIG. 6 illustrates a block configuration of a power converting device according to example 4 which is still another embodiment of the present invention, and illustrates a configuration where a function of the present invention is additionally provided to an existing power converting device in particular. In this example, a signal split circuit 31 is provided between a communication unit 23 and a sensor unit 33 connected with a logic unit 25, and an additional-type determination circuit 36 determines an abnormality. The signal split circuit includes an optical or electrical signal split circuit, and an output buffer circuit 32 which transmits a result of the optical or electrical signal split circuit to the additional-type determination circuit 36. A level determination circuit 34 stabilizes a numerical value of this output, and a delay time calculation abnormality determination circuit 35 receives an input of a delay time and a drive condition and outputs a determination result based on the delay time and the drive condition to an external output circuit 8 or the logic unit 25. By employing such a configuration, it is possible to add to existing products a function of detecting a temperature abnormality and evaluating a remaining operational life. Further, when the power converting device is inspected on a regular basis, it is possible to check soundness of the power converting device by temporarily inserting and operating the signal split circuit 31 and the additional-type determination circuit 36 and evaluating a delay time.

As described above, according each of the examples of the present invention, it is possible to provide a power converting device which can precisely detect an abnormality and deterioration of a power semiconductor and the power converting device related to the power semiconductor by detecting a temperature based on a delay time of a drive instruction to the power semiconductor and a drive voltage and precisely prevent a trouble such as a failure while employing a simple configuration, and enable long-time use.

### Reference Signs List

- 1: power semiconductor
- 2: drive circuit
- 3: drive instruction arithmetic operation circuit
- 4: delay calculation circuit
- 5: abnormality determination circuit
- 6: recording determination circuit
- 7: instruction arithmetic operation circuit
- 8: external output circuit
- 9: load
- 11, 12: IGBT
- 13: current sensor
- 14: electric motor
- 15: power supply
- 16: temperature sensor
- 17: voltage sensor
- 18, 19: communication means
- 20: voltage determination circuit
- 21, 22: driving unit
- 23, 24: communication unit
- 25: logic unit
- 31: signal split circuit
- 32: output buffer circuit
- 33: sensor unit
- 34: level determination circuit
- 35: delay calculation/abnormality determination circuit
- 36: additional-type determination circuit

## Claims

1. A power converting device comprising:
a power semiconductor (1) configured to drive a load (9); and
a drive instruction arithmetic operation circuit (3) configured to provide a drive instruction to conduct or interrupt the power semiconductor (1); and
a drive circuit (2) configured to convert the drive instruction generated by the drive instruction arithmetic operation circuit (3) into a drive voltage, and control conduction and interruption of the power semiconductor (1),
the power converting device **characterized by** further comprising:
a voltage determination circuit (20) configured to compare the drive voltage and a predefined threshold voltage value for determining whether the drive voltage is higher or lower than the predefined threshold voltage value,
a delay calculation unit (4) configured to receive the result of the determination of the voltage determination circuit (20), to calculate a delay time from a time of the drive instruction until the receiving of the result of the determination, and to input the delay time into a recording determination circuit (6) of the power converting device,
the recording determination circuit (6) configured to record whilst the load (9) is driven under a specific drive condition, the delay time as a reference value at a set timing, which is a time at which the power converting device starts operating, and
the power conversion device further configured to compare the delay time recorded by the recording determination device (6) and a subsequent delay time calculated by the delay calculation unit (4) whilst the load (9) is driven under the specific drive condition and to determine whether an abnormality of the power semiconductor or the power converting device has occurred, record or display and output a result of the determination, or change at least one of the drive instruction and the drive voltage based on a result of the comparison between the delay time and the reference value and the determination of the abnormality of the power semiconductor or the power converting device, wherein
the specific drive condition for making comparison with and determination on the reference value is one of an output current value of the power converting device, a direction of an output current flowing the power semiconductor (1), an inter-output terminal voltage of the power semiconductor (1), a power voltage and a temperature in the power converting device or a combination of the output current value, the direction, the inter-output terminal voltage, the power voltage and the temperature.

2. The power converting device according to claim 1, wherein the power semiconductor (1) includes an insulation gate bipolar transistor, a power MOSFET or a MOS gate control power semiconductor element.

3. The power converting device according to claim 1, further comprising a drive instruction arithmetic operation circuit (7) configured to control the drive instruction arithmetic operation circuit (3) to thereby change the drive instruction or the drive voltage to interrupt the power semiconductor (1) for a certain period of time based on the result of the comparison and the determination.

4. The power converting device according to claim 1, further comprising an instruction arithmetic operation circuit (7) configured to control the drive instruction arithmetic operation circuit (3) to thereby change decrease an upper limit value of a current flowing to the power semiconductor (1), decrease a time width of a conduction instruction of the power semiconductor (1) according to the drive instruction or decrease a frequency to control the conduction and the interruption based on the result of the comparison and the determination.

5. The power converting device according to claim 1, further comprising communication means (19) configured to communicate to the delay calculation unit (4) a signal of a result indicating that the output voltage of the drive circuit (2) has reached the predetermined threshold voltage value.

## Patentansprüche

1. Leistungsumsetzungsvorrichtung, die Folgendes umfasst:
einen Leistungshalbleiter (1), der konfiguriert ist, eine Last (9) anzusteuern; und
eine Ansteueranweisungs-Arithmetikvorgangsschaltung (3), die konfiguriert ist, eine Ansteueranweisung, um den Leistungshalbleiter (1) durchzuschalten oder zu unterbrechen, bereitzustellen; und
eine Ansteuerschaltung (2), die konfiguriert ist, die Ansteueranweisung, die durch die Ansteueranweisungs-Arithmetikvorgangsschaltung (3) erzeugt wird, in eine Ansteuerspannung umzusetzen und Leitung und Unterbrechung des Leistungshalbleiters (1) zu steuern,
wobei die Leistungsumsetzungsvorrichtung **dadurch gekennzeichnet ist, dass** sie ferner Folgendes umfasst:
eine Spannungsbestimmungsschaltung (20), die konfiguriert ist, zum Bestimmen, ob die Ansteuerspannung höher oder niedriger als ein vorgegebener Schwellenspannungswert ist, die Ansteuerspannung und den vorgegebenen Schwellenspannungswert zu vergleichen,
eine Verzögerungsberechnungseinheit (4), die konfiguriert ist, das Ergebnis der Bestimmung der Spannungsbestimmungsschaltung (20) zu empfangen, eine Verzögerungszeit von einem Zeitpunkt der Ansteueranweisung bis zum Empfangen des Ergebnisses der Bestimmung zu berechnen und die Verzögerungszeit in eine Aufzeichnungsbestimmungsschaltung (6) der Leistungsumsetzungsvorrichtung einzugeben,
die Aufzeichnungsbestimmungsschaltung (6), die konfiguriert ist, während die Last (9) unter einer bestimmten Ansteuerbedingung angesteuert wird, die Verzögerungszeit als einen Referenzwert bei einer eingestellten Zeitvorgabe, die eine Zeit ist, zu der die Leistungsumsetzungsvorrichtung beginnt zu arbeiten, aufzuzeichnen, und
wobei die Leistungsumsetzungsvorrichtung ferner konfiguriert ist, die Verzögerungszeit, die durch die Aufzeichnungsbestimmungsvorrichtung (6) aufgezeichnet wird, und eine nachfolgende Verzögerungszeit, die durch die Verzögerungsberechnungseinheit (4) berechnet wird, während die Last (9) unter der bestimmten Ansteuerbedingung angesteuert wird, zu vergleichen und zu bestimmen, ob eine Anomalie des Leistungshalbleiters oder der Leistungsumsetzungsvorrichtung aufgetreten ist, ein Ergebnis der Bestimmung aufzuzeichnen oder anzuzeigen und auszugeben oder die Ansteueranweisung und/oder die Ansteuerspannung auf der Grundlage eines Ergebnisses des Vergleichs zwischen der Verzögerungszeit und dem Referenzwert und der Bestimmung der Anomalie des Leistungshalbleiters oder der Leistungsumsetzungsvorrichtung zu ändern, wobei
die bestimmte Ansteuerbedingung zum Durchführen des Vergleichs mit dem Referenzwert und der Bestimmung auf der Grundlage des Referenzwertes entweder ein Ausgangsstromwert der Leistungsumsetzungsvorrichtung oder eine Richtung eines Ausgangsstroms, der aus dem Leistungshalbleiter (1) fließt, oder eine Spannung zwischen den Ausgangsanschlüssen des Leistungshalbleiters (1) oder eine Leistungsspannung oder eine Temperatur in der Leistungsumsetzungsvorrichtung oder eine Kombination des Ausgangsstromwertes, der Richtung, der Spannung zwischen den Ausgangsanschlüssen, der Leistungsspannung und der Temperatur ist.

2. Leistungsumsetzungsvorrichtung nach Anspruch 1, wobei der Leistungshalleiter (1) einen bipolaren Transistor mit isoliertem Gate, einen Leistungs-MOSFET oder ein MOS-Gate-Steuerungs-Leistungshalbleiterelement enthält.

3. Leistungsumsetzungsvorrichtung nach Anspruch 1, die ferner eine Ansteueranweisungs-Arithmetikvorgangsschaltung (7) umfasst, die konfiguriert ist, auf der Grundlage des Ergebnisses des Vergleichs und der Bestimmung die Ansteueranweisungs-Arithmetikvorgangsschaltung (3) derart zu steuern, dass dadurch die Ansteueranweisung oder die Ansteuerspannung geändert wird, um den Leistungshalbleiter (1) für einen bestimmten Zeitraum zu unterbrechen.

4. Leistungsumsetzungsvorrichtung nach Anspruch 1, die ferner eine Anweisungs-Arithmetikvorgangsschaltung (7) umfasst, die konfiguriert ist, auf der Grundlage des Ergebnisses des Vergleichs und der Bestimmung die Ansteueranweisungs-Arithmetikvorgangsschaltung (3) derart zu steuern, dass dadurch ein oberer Grenzwert eines Stroms, der zum Leistungshalbleiter (1) fließt, vermindert wird, eine Zeitspanne einer Leitungsanweisung des Leistungshalbleiters (1) gemäß der Ansteueranweisung vermindert wird oder eine Frequenz, um die Leitung und die Unterbrechung zu steuern, vermindert wird.

5. Leistungsumsetzungsvorrichtung nach Anspruch 1, die ferner Kommunikationsmittel (19) umfasst, die konfiguriert sind, ein Signal eines Ergebnisses, das angibt, dass die Ausgangsspannung der Ansteuerschaltung (2) den vorgegebenen Schwellenspannungswert erreicht hat, an die Verzögerungsberechnungseinheit (4) zu kommunizieren.

## Revendications

1. Dispositif convertisseur de puissance comprenant :
un semi-conducteur de puissance (1) configuré pour piloter une charge (9) ; et
un circuit d'opérations arithmétiques d'instruction pilote (3) configuré pour fournir une instruction pilote pour conduire ou interrompre le semi-conducteur de puissance (1) ; et
un circuit pilote (2) configuré pour convertir l'instruction pilote générée par le circuit d'opérations arithmétiques d'instruction pilote (3) en une tension pilote, et pour commander une conduction ou une interruption du semi-conducteur de puissance (1),
le dispositif convertisseur de puissance étant **caractérisé en ce qu'**il comprend en outre :
un circuit de détermination de tension (20) configuré pour comparer la tension pilote et une valeur de tension seuil prédéfinie pour déterminer si la tension pilote est plus élevée ou plus basse que la valeur de tension seuil prédéfinie,
une unité de calcul de retard (4) configurée pour recevoir le résultat de la détermination du circuit de détermination de tension (20), pour calculer un temps de retard à partir d'un temps de l'instruction pilote jusqu'à la réception du résultat de la détermination, et pour entrer le temps de retard jusque dans un circuit de détermination d'enregistrement (6) du dispositif convertisseur de puissance,
le circuit de détermination d'enregistrement (6) étant configuré pour enregistrer, tandis que la charge (9) est pilotée sous une condition pilote spécifique, le temps de retard à titre de valeur de référence à une temporisation fixée, qui est un temps auquel le dispositif convertisseur de puissance commence à fonctionner, et
le dispositif convertisseur de puissance est en outre configuré pour comparer le temps de retard enregistré par le dispositif de détermination d'enregistrement (6) et un temps de retard suivant calculé par l'unité de calcul de retard (4) tandis que la charge (9) est pilotée sous la condition pilote spécifique, et pour déterminer si une anomalie du semi-conducteur de puissance ou du dispositif convertisseur de puissance est survenue, pour enregistrer ou afficher et sortir un résultat de la détermination, ou pour changer au moins un élément parmi l'instruction pilote et la tension pilote sur la base d'un résultat de la comparaison entre le temps de retard et la valeur de référence et de la détermination de l'anomalie du semi-conducteur de puissance ou du dispositif convertisseur de puissance, dans lequel
la condition pilote spécifique pour établir une comparaison avec et une détermination sur la valeur de référence est un élément parmi une valeur de courant de sortie du dispositif convertisseur de puissance, une direction d'un courant de sortie s'écoulant jusqu'au semi-conducteur de puissance (1), une tension entre des bornes de sortie du semi-conducteur de puissance (1), une tension d'alimentation et une température dans le dispositif convertisseur de puissance, ou une combinaison de la valeur de courant de sortie, de la direction, de la tension entre les bornes de sortie, de la tension d'alimentation et de la température.

2. Dispositif convertisseur de puissance selon la revendication 1, dans lequel le semi-conducteur de puissance (1) inclut un transistor bipolaire à grille isolée, un MOSFET de puissance ou un élément semi-conducteur de puissance de commande à grille MOS.

3. Dispositif convertisseur de puissance selon la revendication 1, comprenant en outre un circuit d'opérations arithmétiques d'instruction (7) configuré pour commander le circuit d'opérations arithmétiques d'instruction pilote (3) pour ainsi changer l'instruction pilote ou la tension pilote pour interrompre le semi-conducteur de puissance (1) pendant une certaine période de temps sur la base du résultat de la comparaison et de la détermination.

4. Dispositif convertisseur de puissance selon la revendication 1, comprenant en outre un circuit d'opérations arithmétiques d'instruction (7) configuré pour commander le circuit d'opérations arithmétiques d'instruction pilote (3) pour ainsi changer une diminution d'une valeur limite supérieure d'un courant s'écoulant jusqu'au semi-conducteur de puissance (1), une diminution d'un laps de temps d'une instruction de conduction du semi-conducteur de puissance (1) en accord avec l'instruction pilote ou une diminution d'une fréquence pour commander la conduction et l'interruption sur la base du résultat de la comparaison et de la détermination.

5. Dispositif convertisseur de puissance selon la revendication 1, comprenant en outre un moyen de communication (19) configuré pour communiquer à l'unité de calcul de retard (4) un signal d'un résultat indiquant que la tension de sortie du circuit pilote (2) a atteint la valeur de tension seuil prédéterminée.
